Europäisches Patentamt

European Patent Office

Office européen des brevets

(19)

(11) Numéro de publication: **0 206 370**
**B1**

(12) FASCICULE DE BREVET EUROPEEN

(45) Date de publication du fascicule du brevet:
**14.03.90**

(21) Numéro de dépôt: **86200790.3**

(22) Date de dépôt: **05.05.86**

(51) Int. Cl.⁴: **C30B 13/18**, C30B 25/16,
C23C 16/44

(54) **Procédé de réalisation d'un dispositif semiconducteur, incluant le dépôt en phase vapeur de couches cristallines sur un substrat.**

(30) Priorité: **13.05.85 FR 8507204**

(43) Date de publication de la demande:
**30.12.86 Bulletin 86/52**

(45) Mention de la délivrance du brevet:
**14.03.90 Bulletin 90/11**

(84) Etats contractants désignés:
**DE FR GB IT NL**

(56) Documents cités:
**DE-A- 3 136 895**
**US-A- 4 190 470**
**US-A- 4 393 013**

(73) Titulaire: **LABORATOIRES D'ELECTRONIQUE PHILIPS,
3, Avenue Descartes, F-94450 Limeil-Brévannes(FR)**
(84) Etats contractants désignés: **FR**

(73) Titulaire: **N.V. Philips' Gloeilampenfabrieken,
Groenewoudseweg 1, NL-5621 BA Eindhoven(NL)**
(84) Etats contractants désignés: **DE GB IT NL**

(72) Inventeur: **Frijlink, Peter Michael, Société Civile
S.P.I.D. 209 Rue de l'Université, F-75007 Paris(FR)**

(74) Mandataire: **Landousy, Christian et al, Société Civile
S.P.I.D. 209, Rue de l'Université, F-75007 Paris(FR)**

**Description**

L'invention concerne un procédé de réalisation d'un dispositif semiconducteur, incluant le dépôt en phase vapeur de couches cristallines sur un substrat, dans la chambre d'un réacteur, à l'aide de gaz vecteurs et de gaz réactants.

Par gaz réactant, l'on entend tout gaz nécessaire à la réalisation d'une opération ou réaction.

Par réacteur, l'on entend tout lieu, ou toute enceinte où se fait l'opération ou la réaction.

Par gaz vecteur, il convient d'entendre tout gaz compatible avec la réaction ou l'opération, mais ne prenant pas nécessairement part à cette opération ou réaction. Ce peut être par exemple un gaz complètement neutre vis-à-vis de la réaction, ou bien constituant l'atmosphère ou le milieu favorable à la bonne mise en oeuvre de la réaction.

L'invention trouve son application dans la réalisation de dispositifs actifs semiconducteurs incluant des couches épitaxiales ou des couches implantées, par exemple en matériaux du groupe III-V.

Il est connu du brevet US-3 930 908 d'introduire dans la chambre d'un réacteur d'épitaxie en phase vapeur, au moyen de vannes de structures classiques, des composés gazeux réactants mêlés à un gaz vecteur. La régulation, l'interruption ou la commutation de l'écoulement de ces gaz sont alors faites suivant les cas, par l'ouverture la fermeture de robinets ou de vannes, mettant en oeuvre le déplacement de pièces mécaniques les unes par rapport aux autres.

Cependant, l'utilisation de ces robinets ou de ces vannes classiques se révèle difficile, voire même impossible dans de nombreux cas et en particulier :
- lorsque les gaz utilisés sont corrosifs,
- lorsque ces gaz sont polluants et qu'une décontamination est nécessaire pour réaliser la commutation ultérieure avec un autre gaz : cette décontamination est rendue difficile du fait que les matériaux que constituent les vannes sont le plus souvent attaqués par les produits utilisés pour la décontamination,
- lorsque ces gaz doivent être maintenus à haute température durant leur écoulement, ce qui peut être le cas de composés gazeux qui cristallisent à température ambiante, ou se solidifient : en effet, aux températures élevées d'épitaxie en phase vapeur, telles que les températures comprises entre 600 et 900°C, les matériaux qui répondent aux conditions de pureté imposées par l'épitaxie en phase vapeur, ne sont pas des matériaux qui permettent de réaliser de façon simple des vannes qui répondent aux conditions d'étanchéité,
- lorsque ces gaz doivent être utilisés sous de très faible débit ou en très faible quantité ; en effet les variations de pression parasites dues à la commutation peuvent engendrer des erreurs sur l'épaisseur des couches épitaxiales ou des erreurs sur le dopage des couches réalisées.

Ainsi, pour ces raisons, d'une façon générale en épitaxie en phase vapeur, les métaux ou les matériaux céramiques sont exclus pour la raison qu'il peuvent contaminer, ou être attaqués par le gaz réactant.

Et d'autre part, des épaisseurs de couches très minces, des changements de composition abrupts ou des changements de dopage abrupts ne peuvent pas être obtenus au moyen des vannes de structure classique.

Pour toutes ces raisons, les vannes classiques doivent être évitées.

C'est pourquoi la présente invention propose un procédé de réalisation qui est dénué de ces inconvénients.

Selon la présente invention ce but est atteint à l'aide d'un procédé tel que défini dans le préambule, caractérisé en ce que les gaz vecteurs et réactants sont introduits dans la chambre du réacteur au moyen d'un ou plusieurs système(s) de tube composé(s) chacun d'une part d'un tube principal dont une extrémité débouche dans le réacteur et dont l'autre extrémité débouche sur une sortie, et d'autre part de trois tubes secondaires dits premier, deuxième et troisième tubes secondaires, ledit tube principal comportant quatre restrictions entre lesquelles débouchent respectivement les trois tubes secondaires, ledit premier tube secondaire débouchant le plus près du réacteur, et en ce que le premier et le troisième tube secondaires servent à transporter le (ou les) gaz vecteur(s) avec les débits respectifs $D_1$ et $D_3$ alors que le deuxième tube secondaire sert à transporter le gaz réactant avec le débit $D_2$, de telle manière que ce système de tubes :

a) est équivalent à une vanne guidant le gaz réactant vers le réacteur lorsque :
$D_3 > D_1$ et $D_3 > D_2$
b) est équivalent à une vanne guidant le gaz réactant vers la sortie lorsque :
$D_1 > D_3$ et $D_1 > D_2$

Le procédé selon l'invention présente, entre autres, les avantages suivants :
- le système de tubes, qui consitue à lui seul la vanne d'introduction des gaz réactants dans la chambre, pouvant être réalisé en un matériau tel que le quartz qui répond aux conditions de pureté, des couches épitaxiales d'une très grande qualité peuvent être obtenues ; de plus, lorsque le système de tubes est réalisé en un tel matériau, la décontamination éventuelle est facilement obtenue à l'aide d'un gaz chloré par exemple, ce qui rend la mise en oeuvre du procédé de réalisation des couches épitaxiales plus simple, et garantit le maintien de la qualité des couches au cours du temps ;
- le système de tubes permettant une commutation rapide dénuée d'espaces morts où le gaz reste stagnant et où sont engendrées des traînées de composé gazeux après commutation, des épaisseurs de couches très minces, des changements de composition abrupts ou des changements de dopage abrupts peuvent être obtenus;

D'une façon générale, à l'aide du procédé selon l'invention les couches épitaxiales ou implantées sont obtenues de façon plus simple et sont de meilleure qualité.

L'invention sera mieux comprise à l'aide de la description suivante illustrée par les figures annexées dont:

- la figure 1a qui représente schématiquement le dispositif utilisé pour la mise en œuvre du procédé selon l'invention;
- la figure 1b qui représente, vues en coupe et agrandies les portions de tubes de la zone Z de la figure 1a délimitée par un trait discontinu;
- la figure 2 qui représente schématiquement un réacteur pour l'élaboration de couches cristallines par épitaxie en phase gazeuse, ce réacteur étant muni d'un dispositif utilisé pour la mise en œuvre du procédé selon l'invention;
- la figure 3 qui représente schématiquement un réacteur muni de différentes sources de gaz réactants par l'intermédiaire de dispositifs utilisés pour la mise en œuvre du procédé selon l'invention.

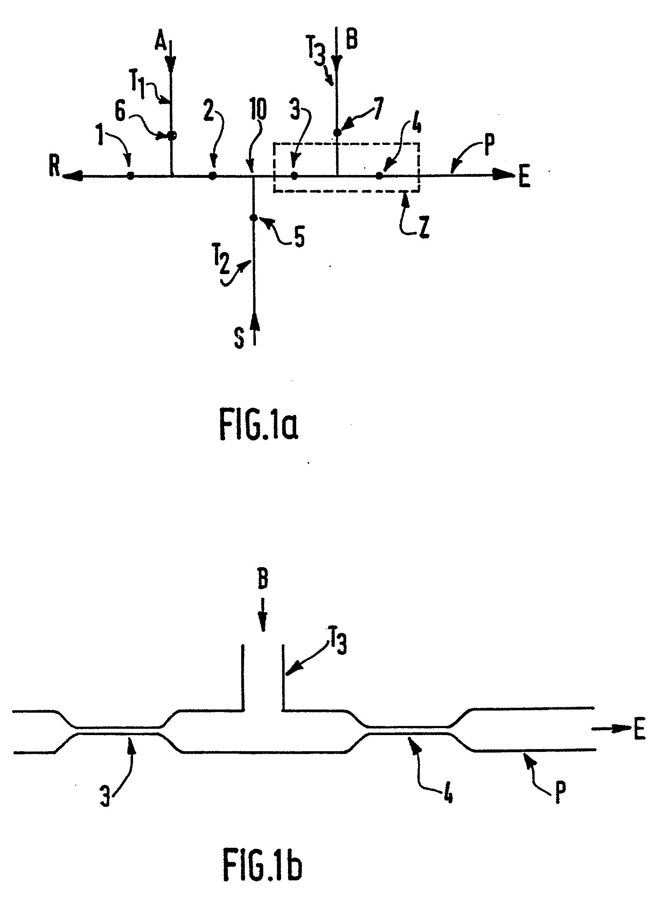

Pour mettre en œuvre le procédé de réalisation selon l'invention, on utilise de préférence le dispositif représenté schématiquement sur la figure 1a. Ce dispositif comprend un système de tubes P, $T_1$, $T_2$ et $T_3$ munis de restrictions 1, 2, 3, 4, 5, 6 et 7.

En particulier ce système de tubes est constitué d'un tube principal P muni de quatre restrictions numérotées 1, 2, 3 et 4. Entre les restrictions 1 et 2, débouche dans P un tube secondaire $T_1$; entre les restrictions 2 et 3 débouche un tube secondaire $T_2$; et entre les restrictions 3 et 4 débouche un tube secondaire $T_3$.

L'extrémité du tube P située du côté de la restriction 1 débouche dans un réacteur R ou dans une enceinte R d'utilisation d'un gaz dit gaz réactant S. Ce gaz réactant S est introduit dans le dispositif par le deuxième tube secondaire $T_2$. L'autre extrémité du tube principal P, est une sortie E du dispositif utilisé pour la mise en œuvre du procédé selon l'invention vers, par exemple, une enceinte de récupération des gaz non utilisés dans le réacteur.

Par les tubes $T_1$ et $T_3$ sont introduits des gaz dits vecteurs qui peuvent être neutres vis-à-vis de l'utilisation faite du gaz réactant dans le réacteur, ou bien compatibles avec cette utilisation ou enfin former le milieu ou l'atmosphère favorable à la réalisation de la réaction. Ce peut être également un gaz réactant dans certaines proportions.

Un détail de la zone Z du dispositif utilisé pour la mise en œuvre du procédé selon l'invention est représenté sur la figure 1b, agrandi par rapport à la figure 1a. Les restrictions 3 et 4 qui y sont montrées sont des rétrécissements de la section du tube principal P sur une certaine longueur. Le tube $T_3$ débouche entre ces deux rétrécissements.

Les autres rétrécissements et les autres débouchés de tubes secondaires du dispositif sont tout à fait conformes à la structure montrée sur la figure 1b.

Lorsque l'on impose des débits respectivement $D_1$, $D_2$, $D_3$ aux gaz introduits par les tubes secondaires $T_1$, $T_2$, $T_3$, plusieurs situations apparaissent.

En premier lieu lorsque les débits $D_1$ et $D_3$ des gaz vecteurs sont absolument égaux, le courant du gaz S se divise en deux parties égales dont une s'écoule en direction de R, et dont l'autre s'écoule en direction de E.

En second lieu, lorsque le débit $D_1$ est augmenté et/ou le débit $D_3$ diminué, le débit dans la restriction 2 étant choisi suffisamment grand pour empêcher une rétrodiffusion gênante du réactant S contre le sens du flux, alors la direction du flux dans ladite restriction 2 est inversée par rapport à la situation précédente et le gaz réactant s'écoule totalement en direction de la sortie E. Ceci correspond aux conditions où

$$D_1 > D_3 \text{ et } D_1 > D_2$$

En troisième lieu lorsque le débit $D_3$ est augmenté et/ou le débit $D_1$ diminué, le débit dans la restriction 3 étant choisi suffisamment grand pour empêcher une retrodiffusion gênante du réactant S dans la restriction 2 contre le sens du flux, alors le réactant S s'écoule totalement en direction de R. Ceci correspond aux conditions où : $D_3 > D_1$ et $D_3 > D_2$.

Pour éviter le retour des gaz vers leur source, chacun des tubes secondaires $T_1$, $T_2$, $T_3$ peut en outre être muni de restrictions, respectivement 6, 5, 7.

Le système de tubes décrit précédemment peut être avantageusement utilisé pour introduire les différents gaz réactants dans un réacteur destiné à la réalisation de couches cristallines par épitaxie en phase gazeuse.

Le procédé de réalisation selon l'invention peut être mise en œuvre au moyen d'un système d'épitaxie en phase gazeuse qui comprend d'une part, un réacteur R dans lequel est placé un échantillon X, et au moins une bouteille S d'un gaz réactant, et, d'autre part, au moins un dispositif formé de tubes munis de restrictions tel que décrit précédemment, pour amener le gaz réactant de la source S dans le réacteur R.

Pour obtenir sur l'échantillon X, consistant en un substrat monocristallin, l'élaboration de couches épitaxiales dont la composition et le dopage sont très précis, il est indispensable que la pression partielle des gaz réactants dans la chambre R de dépôt soit à tout moment bien contrôlée. De plus, une alternance de couches très minces peut aussi être désirée. Dans ce cas, la pression partielle de chacun des gaz réactants doit être bien contrôlée.

Or, si des gaz sont introduits dans le réacteur R à partir de plusieurs bouteilles sources telles que S et que la commutation entre ces différentes sources est faite à l'aide de simples vannes, il est improbable que la pression totale de gaz à la sortie des sources reste constante.

En effet, ces bouteilles sources, dans les espaces situés au-dessus du produit de départ, sont remplies d'une certaine quantité de vapeur saturée de celui-ci. Les changements de pression, au moment des commutations, provoquent la sortie indésirable de vapeur saturée de cet espace vers la chambre de réaction R. Ainsi la commutation d'une vanne de type courant peut provoquer en sortie d'une source une variation de pression de l'ordre de 1 % entraînant le dépôt intempestif sur le substrat d'une couche épitaxiale de plusieurs nanomètres.

Le remplacement d'une vanne classique par un dispositif utilisé pour la mise en œuvre du procédé selon l'invention, tel que décrit précédemment placé entre la source de gaz S et la chambre de réaction R permet de s'affranchir de ces problèmes, comme le montre le procédé de réalisation de couches cristallines décrit ci-après à titre d'exemple mettant en oeuvre ce dispositif.

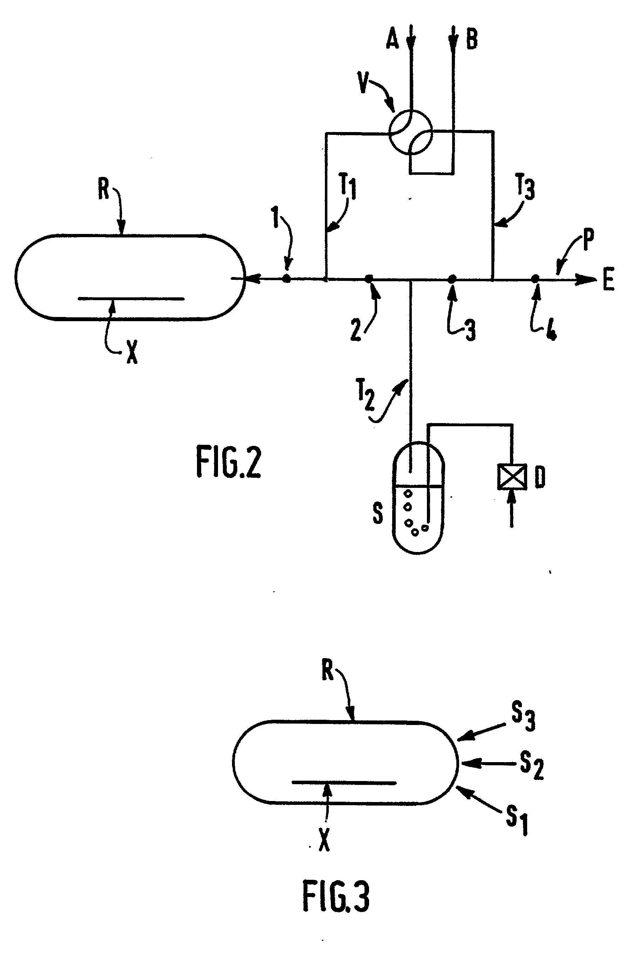

Le dispositif utilisé pour la mise en œuvre du procédé selon l'invention est celui de la figure 3, à ceci près que plusieurs gaz réactants $S_1$, $S_2$, $S_3$ sont utilisés et amenés chacun au réacteur par l'intermédiaire d'un dispositif selon la figure 2.

Le système est prévu pour obtenir l'alternance de couches d'arséniure de gallium (GaAs) et d'arséniure de gallium et d'aluminium ($Ga_{1-x}Al_x As$) sur un substrat en arséniure de gallium (GaAs) par la méthode aux organo-métalliques à partir de triméthylgallium (TMG), de triméthylaluminium (TMA) et d'arsine ($ASH_3$) en atmosphère d'hydrogène, ou d'hélium.

Une bouteille $S_1$ fournira par exemple le TMG, une bouteille $S_2$ fournira le TMA, l'arsine sera introduite par $S_3$ sous forme gazeuse. Chacun de ces produits sera introduit au moment voulu dans la réacteur par la voie destinée au gaz réactant d'un dispositif identique au dispositif représenté figure 2. Le gaz vecteur choisi sera ici l'hydrogène gazeux ou un gaz neutre.

Le débit du gaz vecteur de valeur haute sera de l'ordre de 200 cm³/min., celui du gaz vecteur de valeur basse de l'ordre de 50 cm³/min.

Le débit du réactant est d'un ordre de grandeur plus faible que le débit du gaz vecteur de valeur haute.

Il peut être réalisé à l'aide du dispositif de la figure 3, une structure composite de couches alternées telles que, sur le substrat en GaAs, une première couche de GaAlAs de 2μm, puis une couche mince de GaAs de 4nm, suivie d'une seconde couche de Ga Al As de 2μm. Ce type de structure composite est nécessaire à la réalisation de dispositifs semiconducteurs tels que des lasers à puits quantiques par exemple.

Les couches minces d'arséniure de gallium sont obtenues par combinaison dans le réacteur, de l'arsenic gazeux et de vapeurs de TMG issues de la bouteille source $S_1$. Les couches épaisses d'arséniure de gallium et d'aluminium sont obtenues par combinaison dans le réacteur de l'arsenic gazeux et de vapeurs de TMG et de TMA issues repsectivement de la bouteille source $S_1$ et de la bouteille source $S_2$.

Il est clair que des couches d'épaisseur aussi faible que 4nm ne pourraient être obtenues de façon reproductible avec le dispositif connu de l'art antérieur puisque la meilleure précision sur l'épaisseur des couches était de plusieurs nm.

Selon l'invention, en faisant arriver dans le réacteur, chaque produit par la voie réactant de chaque système de tubes, non seulement une épaisseur très mince peut être obtenue pour les couches, mais encore cette épaisseur est parfaitement reproductible. De plus les concentrations en réactant peuvent être parfaitement contrôlées, ce qui est un avantage pour la réalisation des couches $Ga_{1-x}A_x As$.

Dans l'exemple décrit, les tubes avaient un diamètre intérieur de l'ordre de 3 mm et les restrictions un diamètre intérieur de l'ordre de 0,3 à 0,5 mm sur une longueur d'environ 20 mm.

L'invention peut être réalisée à l'aide d'autres gaz en mettant en oeuvre un ou plusieurs systèmes de tubes adaptés. Si le gaz réactant présente une masse moléculaire plus grande que celle du gaz vecteur, la viscosité du mélange est alors différente et les valeurs des diamètres des tubes et des restrictions doivent être modifiées en conséquence, ainsi que les valeurs relatives des débits des gaz. Mais la méthode de commutation reste identique.

Pour l'application à la réalisation de couches épitaxiales, le système de tubes et de restrictions sera réalisé de façon préférable en quartz. En effet le quartz répond au mieux aux qualités de pureté pour réaliser de telles couches de bonne qualité car il ne contamine pas les gaz réactants et n'est pas attaqué par ceux-ci. De plus, il possède la propriété d'être facilement débarrassé des traces de matériaux polluants déposés à sa surface. Ce système de tubes permet donc de réaliser la commutation des gaz sans utilisation de vannes ou de matériaux désavantageux.

## Revendications

1. Procédé de réalisation d'un dispositif semiconducteur, incluant le dépôt en phase vapeur de couches cristallines sur un substrat, dans la chambre d'un réacteur, à l'aide de gaz vecteurs et de gaz réactants, caractérisé en ce que les gaz vecteurs et réactants sont introduits dans la chambre du réacteur au moyen d'un ou plusieurs système(s) de tubes composé(s) chacun d'une part d'un tube principal dont une extrémité débouche dans le réacteur et dont l'autre extrémité débouche sur une sortie, et d'autre part de trois tubes secondaires dits premier, deuxième et troisième tubes secondaires, ledit tube principal comportant quatre restrictions entre lesquelles débouchent respectivement les trois tubes secondaires, ledit premier tube secondaire débouchant le plus près du réacteur, et en ce que le premier et le troisième tube secondaires servent à transporter le (ou les) gaz vecteur(s) avec les débits respectifs $D_1$ et $D_3$, alors que le deuxième tube secondaire sert à transporter le gaz réactant avec le débit $D_2$, de telle manière que ce système de tubes:

a) est équivalent à une vanne guidant le gaz réactant vers le réacteur lorsque:
$D_3 > D_1$ et $D_3 > D_2$

b) est équivalent à une vanne guidant le gaz réactant vers la sortie lorsque:
$D_1 > D_3$ et $D_1 > D_2$

2. Procédé selon la revendication 1, caractérisé en ce que le(s) système(s) de tubes est(sont) réalisé(s) en quartz.

3. Procédé selon l'une des revendications 1 ou 2, caractérisé en ce que, pour réaliser une structure composite de couches épitaxiales d'arséniure de gallium et d'aluminium (GaAlAs) et d'arséniure de gallium (GaAs) sur un substrat d'arséniure de gallium (GaAs), les systèmes de tubes sont au nombre de trois, en ce que le gaz vecteur est choisi parmi l'hydrogène ou un gaz neutre, en ce que dans ledit premier système de tubes le gaz réactant est le triméthylgallium (TMG), dans ledit deuxième système de tubes le gaz réactant est le triméthylaluminium (TMA) et dans ledit troisième système de tubes le gaz réactant est l'arsine (AsH3) et en ce que ces gaz réactants sont introduits dans le réacteur chacun par le moyen de son système de tubes respectif en temps voulu pour réaliser par combinaison dans ledit réacteur des couches alternées d'arséniure de gallium et d'aluminium et d'arséniure de gallium, d'épaisseurs et de compositions souhaitées.

## Claims

1. A method of manufacturing a semiconductor device including the step of depositing from a vapour phase crystalline layers on a substrate in a chamber of a reactor by means of vector gases and reacting gases, characterized in that the vector gases and reacting gases are introduced into the chamber of the reactor by means of one or several systems of tubes each composed on the one hand of a main tube, one end of which merges into the reactor and the other end of which merges at an outlet, and on the other hand of three secondary tubes designated as first, second and third secondary tubes, the said main tube comprising four restrictions between which the three respective secondary tubes merge, the said first secondary tube merging closest to the reactor, and in that the first and third secondary tubes serve to transport the vector gas(es) at a flow rate $D_1$ and $D_3$, respectively, while the second secondary tube serves to transport the reacting gas at a flow rate $D_2$ in such a manner that this system of tubes:
a) is equivalent to a valve guiding the reacting gas to the reactor when $D_3 > D_1$ and $D_3 > D_2$,
b) is equivalent to a valve guiding the reacting gas to the outlet when $D_1 > D_3$ and $D_1 > D_2$.

2. A method as claimed in Claim 1, characterized in that the system(s) of tubes is (are) made of quartz.

3. A method as claimed in any one of Claims 1 or 2, characterized in that, in order to obtain a composite structure of epitaxial layers of gallium aluminium arsenide (GaAlAs) and of gallium arsenide (GaAs) on a substrate of gallium arsenide (SaAs), the tube systems are three in number; in that the vector gas is chosen from hydrogen or a neutral gas, and in that in the said first system of tubes the reacting gas is trimethyl gallium (TMG), in the said second system of tubes the reacting gas is trimethyl aluminium (TMA) and in the said third system of tubes the reacting gas is arsine (AsH3), and in that these reacting gases are introduced into the reactor each by means of its respective system of tubes at the desired instant to obtain by combination in the said reactor alternately layers of gallium aluminium arsenide and of gallium arsenide having desired thicknesses and compositions.

## Patentansprüche

1. Verfahren zum Herstellen einer Halbleiteranordnung, wobei in einer Reaktionskammer mit Hilfe von Traggas und Reaktionsgas aus der Dampfphase kristalline Schichten auf einem Substrat abgeschieden werden, dadurch gekennzeichnet, daß das Trag- und Reaktionsgas mittels eines oder mehrerer Systeme zusammengesetzter Rohre in die Reaktionskammer eingeführt werden, wobei jedes dieser Rohre einerseits aus einem Hauptrohr besteht, von dem ein Ende in die Reaktionskammer mündet und das andere Ende bei einem Ausgang mündet, und andererseits aus drei sekundären Rohren, die als erstes, zweites und drittes Sekundärrohr bezeichnet werden, wobei das Hauptrohr vier Verengungen aufweist, zwischen denen je eines der drei Sekundärrohre mündet wobei das erste Sekundärrohr am nächsten bei der Reaktionskammer mündet, und daß das erste und dritte Sekundärrohr zum Transportieren der (oder des) Traggase(s) mit den betreffenden Durchflußleistungen $D_1$ bzw. $D_3$ vorgesehen sind, während das zweite Sekundärrohr zum Transportieren des Reaktionsgases mit der Durchflußleistung $D_2$ vorgesehen ist, und zwar derart, daß das Rohrsystem:
a) als Ventil wirkt, das das Reaktionsgas der Reaktionskammer zuführt, wenn:
$D_3 > D_1$ und $D_3 > D_2$ ist,
b) als Ventil wirkt, das das Reaktionsgas dem Ausgang zuführt, wenn:
$D_1 > D_3$ und $D_1 > D_2$ ist.

2. Verfahren nach Anspruch 1, dadurch gekennzeichnet, daß das (die) Rohrsystem(e) aus Quarz hergestellt ist (sind).

3. Verfahren nach einem der Ansprüche 1 oder 2, dadurch gekennzeichnet, daß zum Herstellen einer zusammengesetzten Struktur aus Epitaxialschichten aus Gallium-Aluminiumarsenid (GaAlAs) und Galliumarsenid (GaAs) auf einem Galliumarsenid-Substrat (GaAs), drei Rohrsysteme vorgesehen sind, daß das Traggas Wasserstoff oder ein neutrales Gas ist, daß das Reaktionsgas in dem ersten Rohrsystem Trimethylgallium (TMG), das Reaktionsgas in dem zweiten Rohrsystem Trimethylaluminium (TMA) und das Reaktionsgas in dem dritten Rohrsystem Arsenwasserstoff (AsH3) ist und daß diese Reaktionsgase je durch das eigene betreffende Rohrsystem in die Reaktionskammer eingeführt werden und zwar in der erforderlichen Zeit zum Herstellen durch Kombination in der genannten Reaktionskammer wechselnder Schichten aus Gallium-Aluminiumarsenid und Galliumarsenid, einer gewünschten Dicke und Zusammensetzung.

FIG.1a

FIG.1b

FIG.2

FIG.3